Europäisches Patentamt

European Patent Office

Office européen des brevets

(19)

(11) **EP 0 588 648 B1**

## (12) EUROPEAN PATENT SPECIFICATION

(45) Date of publication and mention
of the grant of the patent:
**04.02.1998 Bulletin 1998/06**

(51) Int Cl.$^6$: **C08J 5/24**, B29B 11/16

(21) Application number: **93307337.1**

(22) Date of filing: **16.09.1993**

(54) **Glass-cloth epoxy sheet and method and apparatus for manufacturing the same**

Epoxyharz Glasmatte und Verfahren und Vorrichtung zu ihrer Herstellung

Natte de verre de résine époxy, procédé et appareil pour sa fabrication

(84) Designated Contracting States:
**DE FR GB**

(30) Priority: **17.09.1992 JP 247538/92**
**25.09.1992 JP 256201/92**

(43) Date of publication of application:
**23.03.1994 Bulletin 1994/12**

(73) Proprietor: **MITSUBISHI CHEMICAL CORPORATION**
**Chiyoda-ku, Tokyo-to (JP)**

(72) Inventors:
• **Hamano, Shuji, c/o Yokkaichi Sogo Kenkyusho**
**Yokkaichi-shi, Mie-ken (JP)**
• **Okuyama, Katsumi,**
**c/o Yokkaichi Sogo Kenkyusho**
**Yokkaichi-shi, Mie-ken (JP)**

• **Kada, Masumi, c/o Yokkaichi Sogo Kenkyusho**
**Yokkaichi-shi, Mie-ken (JP)**
• **Nemoto, Yosui, c/o Tsukuba Sogo Kenkyusho**
**Ami-machi, Inashiki-gun, Ibaraki-ken (JP)**
• **Higuchi, Sadao, c/o Yokkaichi Jigyosho**
**Yokkaichi-shi, Mie-ken (JP)**
• **Ito, Akiyoshi, c/o Yokkaichi Jigyosho**
**Yokkaichi-shi, Mie-ken (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**US-A- 4 101 693          US-A- 4 327 143**

## Description

The present invention relates to a glass-cloth epoxy sheet usable as a flexible printed circuit or a carrier tape for mounting LSIs or the like, and a method and an apparatus for manufacturing this glass-cloth epoxy sheet. The present invention more particularly relates to a glass-cloth epoxy sheet excellent in various characteristics, such as punching characteristics, evenness in thickness, surface smoothness, homogeneity, adhesive properties of an adhesive, soldering heat resistance, and flexibility, and a method of manufacturing this glass-cloth epoxy sheet.

A flexible printed circuit using a glass-cloth epoxy sheet is generally manufactured as follows. That is, after an adhesive is coated on a glass-cloth epoxy sheet, holes serving as device holes or through holes are formed by punching or the like. Thereafter, a copper foil is laminated on the sheet by using a heat press or a heat roll and etched to form a predetermined circuit pattern.

In the punching of holes in the above manufacturing process, if the interface between glass cloth and an epoxy resin peels off or fibers of the glass cloth come out from the epoxy sheet, a gap is formed in that portion. When an etching solution penetrates into such a gap, a portion that is originally not to be etched is also etched, and this may break the circuit.

This problem arises similarly when voids exist in the glass-cloth epoxy sheet and produce a portion which is inhomogeneous in quality.

If, on the other hand, the glass-cloth epoxy sheet has a portion with an uneven thickness or a surface defective portion such as glass fuzz, a circuit pattern in that portion breaks after etching.

Of these problems, peeling of the interface between the glass cloth and the epoxy resin and coming out of the glass cloth fibers occurring in the punching of holes are generally prevented by improving the adhesive power of the interface between the glass cloth and the epoxy resin by:

a. performing a surface treatment for glass-cloth fibers; or
b. impregnating an epoxy resin composition into the glass cloth for a sufficiently long time period by, e.g., performing the impregnating step twice.

As for unevenness in thickness and mixing of voids, after a varnish of a curing epoxy resin composition is impregnated into the glass cloth, a semi-cured B-stage glass-cloth epoxy sheet having a sticky surface is cut into a predetermined size and heated under pressure by using a heat press or the like, thereby obtaining an even thickness and removing voids. In this manner, glass-cloth epoxy cut sheets for flexible printed circuits are manufactured (one by one), thereby preventing unevenness in thickness and mixing of voids.

As circuit design has advanced and has become sophisticated recently, however, a demand has increasingly arisen not only for an improvement in punching characteristics but for a continuous glass-cloth epoxy sheet which makes continuous formation of circuits feasible. No satisfactory punching characteristics, however, can be obtained by the conventional techniques described above. In addition, the above conventional techniques cannot manufacture a continuous glass-cloth epoxy sheet because evenness in thickness and prevention of mixing of voids are realized by the use of a heat press.

## SUMMARY OF THE INVENTION

It is the first object of the present invention to provide a glass-cloth epoxy sheet with good punching characteristics.

It is the second object of the present invention to provide a method capable of continuously manufacturing a glass-cloth epoxy sheet excellent in, e.g., evenness in thickness, surface smoothness, and homogeneity in quality.

These objects are attained by the method of claim 1.

To improve these objects of the present invention, the present inventors have made extensive studies and found the following. That is, in a glass-cloth epoxy sheet manufactured by the above method with good punching characteristics can be obtained by setting the content of the glass cloth to $0.4X + 25$ wt% to 70 wt% for a thickness $X$ of the glass-cloth epoxy sheet ranging between 20 and 75 $\mu$m.

In addition, a glass-cloth epoxy sheet with good punching characteristics can be obtained by setting the content of the glass cloth to 55 wt% to 70 wt% for a thickness of the glass-cloth epoxy sheet ranging between 75 and 200 $\mu$m.

According to the manufacturing method of the present invention, on the other hand, after a varnish is impregnated continuously into glass cloth in an impregnating tank, this glass cloth is pulled up vertically in a free state from the impregnating tank. Subsequently, the varnish is cured without bringing the surface of the glass cloth impregnated with the varnish into contact with anything. This makes it possible to continuously manufacture a glass-cloth epoxy sheet with a high evenness in thickness and a high homogeneity in quality.

Furthermore, the glass-cloth epoxy sheet with 20 to 200 $\mu$m in thickness is manufactured by using a varnish with a viscosity of 3 to 50 cp in accordance with the above manufacturing method, provides a glass-cloth epoxy sheet having both a high flexibility and a high surface smoothness.

Other features and advantages of the present invention will be apparent from the following description taken in conjunction with the accompanying drawings, in which like reference characters designate the same or similar parts throughout the figures thereof.

BRIEF DESCRIPTION OF THE DRAWINGS

Fig. 1 is a sectional view showing a glass-cloth epoxy sheet according to the embodiment of the present invention;
Fig. 2 is a block diagram showing the arrangement of an apparatus for manufacturing the glass-cloth epoxy sheet shown in Fig. 1; and
Fig. 3 is a table showing the comparison between glass-cloth epoxy sheets according to samples of the present invention and general glass-cloth epoxy sheets.

DETAILED DESCRIPTION OF THE PREFERRED EMBODIMENT

The embodiment of the present invention will be described below with reference to the accompanying drawings.

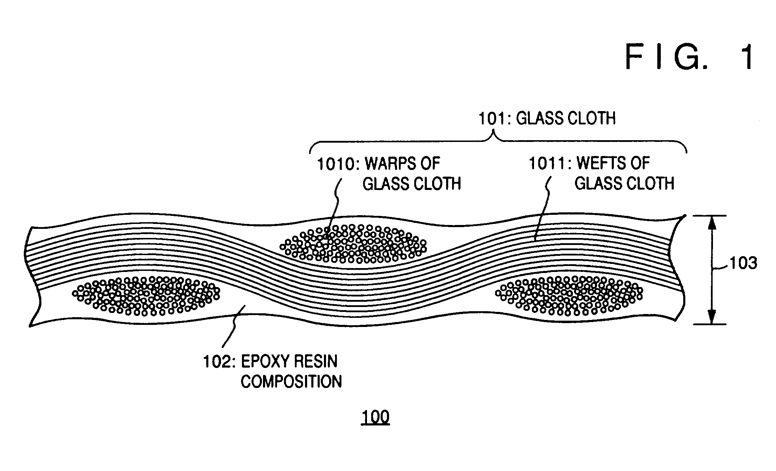

Fig. 1 is a sectional view showing a glass-cloth epoxy sheet according to this embodiment. In Fig. 1, surface unevenness is emphasized for convenience sake. Referring to Fig. 1, this glass-cloth epoxy sheet is generally denoted by reference numeral 100. Reference numeral 1010 denotes warps of glass cloth; 1011, wefts of the glass cloth; 102, epoxy resin portions formed by impregnating a varnish, which is prepared by dissolving a curing epoxy resin composition into a solvent, into glass cloth 101 and curing the varnish; and 103, the thickness of the glass-cloth epoxy sheet.

(1) Curing epoxy resin composition

The curing epoxy resin composition for impregnating glass cloth used in this embodiment is prepared by dissolving a mixture of an epoxy resin and an epoxy hardener into a solvent.

(Epoxy resin)

Examples of the epoxy resin used in this embodiment are a tetraglycidylether epoxy resin, a bisphenol A epoxy resin, a bisphenol F epoxy resin, a novolak epoxy resin, an alicyclic epoxy resin, a glycidylester epoxy resin, a glycidylamine epoxy resin, a heterocyclic epoxy resin, and an urethane-modified epoxy resin. These resins can be used either singly or in the form of a mixture of two or more types of them.

(Epoxy hardener)

Examples of the epoxy hardener used in this embodiment are an amine-based hardener, a polyaminoamide-based hardener, acids and acid anhydrides, dicyandiamide, a basic active hydrogen compound such as organic acid dihydrazide, imidazoles, amineimides, Lewis acid, Brönsted acid salts, and a phenolic resin. These hardeners can be used either singly or in the form of a mixture of two or more types of them.

(Solvent)

Examples of the solvent used in this embodiment are acetone, methylethylketone, toluene, methylcellosolve, and dimethylformamide. These solvents can be used either singly or in the form of a mixture of two or more types of them.

(2) Viscosity of varnish

The varnish used in this embodiment is prepared by dissolving the above-mentioned epoxy resin composition into one or a mixture of two or more types of the solvents described above.
The viscosity of the varnish is adjusted by changing the solvent ratio. If the viscosity of the varnish is less than 3 cp, the varnish flows easily to make it impossible to control the impregnation quantity of the varnish into the glass cloth. If the viscosity of the varnish exceeds 50 cp, on the other hand, the flowability of the varnish lowers, and so the varnish sags unevenly on the surface of the glass cloth. Consequently, the thickness of the resultant glass-cloth epoxy sheet becomes uneven.
The viscosity of the varnish, therefore, must be 3 to 50 cp, more preferably 5 to 30 cp. Note that the measurement of the viscosity in examples to be described later was performed by using an E viscometer.

(3) Thickness (103) of glass-cloth epoxy sheet

If the thickness of the glass-cloth epoxy sheet 100 is less than 20 μm, the glass-cloth epoxy sheet is stretched or broken in the step of coating an adhesive in order to mount LSI chips or the like or in the subsequent step of laminating a copper foil by using a heat roll or the like. If, on the other hand, the thickness of the glass-cloth epoxy sheet exceeds 200 μm, the flexibility of the glass-cloth epoxy sheet is impaired to make continuous coating of an adhesive difficult.

The thickness of the glass-cloth epoxy sheet is therefore 20 to 200 μm, and preferably 30 to 150 μm.

(4) Content of glass cloth 101

If a content of the glass cloth is less than 0.4X + 25 wt% for a thickness X of the glass-cloth epoxy sheet 100 ranging between 20 and 75 μm or if the content is less than 55 wt% for the thickness X ranging between 75 and 200 μm, stiffness decreases and the linear expansion coefficient increases, making it impossible to obtain performance required as a flexible printed circuit. If, on the other hand, the content of the glass cloth exceeds 70 wt%, the amount of the epoxy resin with respect to the glass cloth decreases, resulting in an insufficient adhesion between the glass cloth and the epoxy resin. This causes peeling between the glass cloth and the epoxy resin during punching of holes, whitening the peripheral portions of the holes.

(5) Method of manufacturing glass-cloth epoxy sheet 100

First, a varnish is impregnated into continuous glass cloth. The impregnation of the varnish is preferably performed by arranging a plurality of rolls in an impregnating tank and impregnating the varnish into the glass cloth with the glass cloth in contact with the rolls. This is so because bringing the glass cloth into contact with the rolls squeezes out voids from the glass cloth to allow formation of a homogeneous glass-cloth epoxy sheet containing no voids.

Subsequently, the glass cloth impregnated with the varnish is continuously pulled up vertically in a free state at a constant rate such that the liquid surface of the varnish in the impregnating tank does not ripple. If the liquid surface of the varnish in the impregnating tank ripples, the thickness of the glass-cloth epoxy sheet becomes uneven in the longitudinal direction of the sheet. If the glass-cloth epoxy sheet is not pulled up vertically, the thickness of the glass-cloth epoxy sheet becomes uneven in both the widthwise and longitudinal directions of the sheet.

Curing of the glass-cloth epoxy sheet thus pulled up, i.e., curing of the varnish is performed in a free state in which the surface of the sheet is brought into contact with nothing but hot air. Curing means herein a cured state in which the surface of the glass-cloth epoxy sheet is not damaged even if it is brought into contact with rolls or the like and the weave pattern of the glass cloth does not deform even upon application of an external force within an elastic deformation limit to the sheet. Solvent drying and curing are performed at, for example, normal temperature to 200°C for one to 60 minutes. In situations where the degree of curing needs to be further increased, additional processing, such as curing at 60 to 200°C for 10 minutes to 72 hours may be performed. The cured glass-cloth epoxy sheet is continuously wound up into the form of a roll.

The following two points are important in the manufacturing method of this embodiment.

1) Pulling up the glass-cloth epoxy sheet vertically from the impregnating tank.

If the glass-cloth epoxy sheet is pulled up obliquely, the varnish sags toward the lower surface to cause a difference in the varnish quantity between the upper and lower surfaces.

2) Bringing nothing into contact with the surface of the glass-cloth epoxy sheet before the varnish is cured.

To control the impregnation quantity of the varnish into glass cloth, it is common practice to perform a method of bringing, e.g., a blade or a coil-wound bar into contact with one or both of the surfaces of a glass-cloth epoxy sheet immediately after the sheet is pulled up from an impregnating tank. In this method, excess varnish sags downward unevenly from the coil-wound bar or the like. This produces portions where the varnish sags and portions where it does not or causes differences in the amount of sagged varnish between portions where the varnish sags. Various conditions, e.g., evaporation of the solvent, slightly change depending on these differences, and this degrades evenness in thickness of the glass-cloth epoxy sheet in the widthwise and longitudinal directions of the sheet.

In addition, bringing the coil-wound bar or the like into contact with the glass-cloth epoxy sheet gives damages to the glass cloth, causing breaking of some fibers of the glass cloth or loosening of the fibers into the form of a loop, resulting in glass fuzz. This glass fuzz impairs the surface smoothness of the glass-cloth epoxy sheet after the varnish is cured. Likewise, if the glass-cloth epoxy sheet is brought into contact with the roll before the varnish is cured, the varnish is wiped by the contact pressure, degrading the surface smoothness of the sheet.

(6) Description of manufacturing apparatus

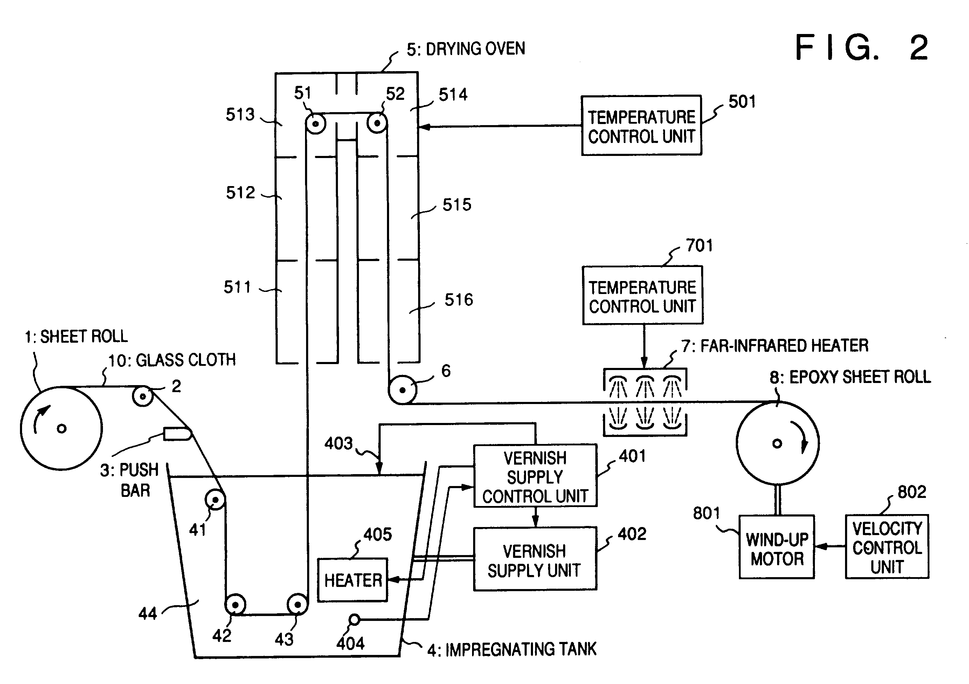

Fig. 2 shows a manufacturing apparatus of this embodiment to which the manufacturing method as described above is applied. Referring to Fig. 2, 1,500 m of 1,050-mm wide, 80-$\mu$m thick glass cloth 10, for example, is wound on a sheet roll 1. This manufacturing apparatus includes rolls for controlling the running direction of the glass cloth, i.e., a delivery guide roll 2, first to third impregnating rolls 41 to 43, first and second oven rolls 51 and 52, and a wind-up guide roll 6. The diameter of the first to third impregnating rolls 41 to 43 is set to be smaller than those of the other rolls in order to prevent mixing of voids during impregnation of the varnish. More specifically, the diameter of the first to third impregnating rolls 41 to 43 is set at about 50 to 80 mm, and the diameters of the other rolls are set at about 100 to 200 mm.

A push bar 3 is made of a material, such as brass, having good sliding properties with respect to glass cloth and is provided between the first roll 2 and the first impregnating roll 41. This push bar 3 slightly pushes the glass cloth 10 outward to thereby discourage formation of wrinkles of the glass cloth 10. The tip of the push bar 3 is rounded so as not to damage the glass cloth 10.

An impregnating tank 4 is of a three-roll type having the first to third impregnating rolls 41 to 43 in order to suppress mixing of voids during impregnation of the varnish. The impregnating tank 4 contains a predetermined amount of a varnish 44 whose viscosity is adjusted in accordance with a glass-cloth epoxy sheet to be manufactured. A liquid level sensor 403 detects the liquid level of the varnish in the impregnating tank 4 and sends a detection signal to a varnish supply control unit 401. On the basis of this detection signal, the varnish supply control unit 401 controls the quantity of the varnish to be supplied to the impregnating tank by a varnish supply unit 402, thereby maintaining the liquid level of the varnish constant. The varnish supply control unit 401 also controls the temperature of a heater 405 in accordance with the temperature of the varnish 44 detected by a temperature sensor 404, maintaining the temperature of the varnish 44 constant to thereby hold its viscosity at a constant value.

A drying oven 5 cures the varnish 44 impregnated into the glass cloth 10 by blowing hot air. The drying oven 5 has six drying chambers 511 to 516 whose temperatures can be set independently of one another. Although the temperatures of the individual drying chambers are determined properly in accordance with the distance and the velocity the glass cloth 10 moves in the oven, they are set such that the varnish is cured at the time the glass cloth 10 touches the first oven roll 51 at the latest. Note that the temperature of each drying chamber is controlled by a temperature control unit 501.

The positions of the first oven roll 51 and the third impregnating roll 43 are set such that the glass cloth 10 impregnated with the varnish 44 is pulled up in a direction perpendicular to the liquid surface of the varnish 44. After the glass cloth 10 passes by the first oven roll 51, the fourth to sixth drying chambers 514 to 516 may be used to further cured the varnish as needed.

A far-infrared heater 7 has a structure in which, for example, a heater is incorporated into earthenware and is arranged at a distance of 40 to 50 cm from the glass cloth 10 with its surface temperature set at approximately 500°C. The far-infrared heater 7 is used when the running velocity of the glass cloth 10 is high or when the degree of curing needs to be further increased. The temperature of the far-infrared heater 7 is controlled by a temperature control unit 701.

An epoxy sheet roll 8 winds up the glass-cloth epoxy sheet in which the varnish is cured completely. A wind-up motor 801 drives the epoxy sheet roll 8. A velocity control unit 802 controls the conveyance velocity of the glass cloth 10 in this apparatus by adjusting the speed of the wind-up motor 801. Braking means (not shown) is also provided at, for example, the axis of the sheet roll 1 to prevent wrinkles of the glass cloth 10 and keep its tension constant. If necessary, driving units may be provided for the individual rolls (2, 41 to 43, 51, 52, and 6) shown in Fig. 2 to assist conveyance of the glass cloth 10. It is also possible to provide driving rolls in addition to those shown in Fig. 2, thereby assisting conveyance of the glass cloth 10. Note that if a driving roll is additionally arranged between the impregnating roll 43 and the first oven roll 51, it is required that the varnish be cured before it contacts the additional driving roll.

(7) Comparison between samples

Comparison between samples (ten types) according to this embodiment and comparative samples (five types) falling outside the range of the embodiment will be described.

<Samples 1 - 6>

Samples 1 to 6 were formed from the following materials under the following conditions by using the apparatus shown in Fig. 2.

1) Epoxy resin composition

The epoxy resins, the epoxy hardeners, and the solvents used and their mixing ratios were as follows.

| (Epoxy resin) | |
|---|---|
| Tetraglycidylether epoxy resin | 30 parts by weight |
| ("EPICOAT 1031S" available from Yuka Shell Epoxy K.K.: epoxy equivalent weight 195) | |
| Bisphenol epoxy resin | 40 parts by weight |
| ("EPICOAT 1001" available from Yuka Shell Epoxy K.K.: epoxy equivalent weight 460) | |
| Halogenated novolak epoxy resin | 30 parts by weight |
| ("BUREN" available from NIPPON KAYAKU CO., LTD.: bromine content 36 wt%, epoxy equivalent weight 285) | |

| (Epoxy hardener) | |
|---|---|
| Dicyandiamide | 5 parts by weight |
| Imidazole-based hardener | 0.5 parts by weight |
| ("IB2MZ" available from Shikoku Chemicals Corp.) | |

(Solvent)

Solvent mixture of methylethylketone/methylcellosolve = 3/1 (weight ratio)

2) Viscosity

By adjusting the amount of the solvent mixture, varnishes with viscosities of 5, 10, 15, 20, 25, and 30 cp were prepared for samples 1 to 6, respectively.

3) Conditions (common to samples 1 to 6)

| | |
|---|---|
| Varnish temperature | 30°C |
| Glass cloth density | 60 warps/25 mm |
| | 64 wefts/25 mm |
| Glass cloth thickness | 80 μm |
| Glass cloth dimensions | width 1,040 mm |
| | length 500 m |
| Glass cloth running velocity | 3 m/min |
| Drying oven stroke | 20 m |
| Drying oven temperature | 1st chamber 130°C |
| | 2nd to 6th chambers 170°C |
| Far-infrared heater | used |

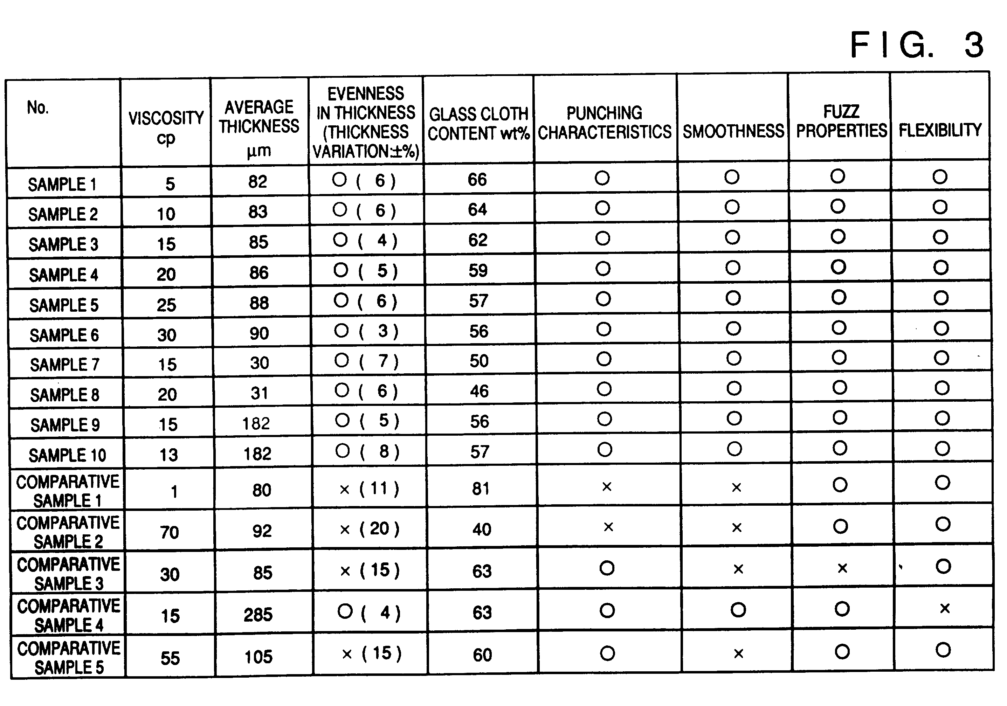

Fig. 3 shows the evaluation results of samples 1 to 6 manufactured under the above conditions.

<Samples 7 & 8>

Only the conditions below were changed among the conditions for samples 1 to 6.

| | |
|---|---|
| Varnish | the same as samples 3 and 4 (15 cp and 20 cp) |
| Glass cloth density | 60 warps/25 mm |
| | 52 wefts/25 mm |
| Glass cloth thickness | 25 μm |

Glass-cloth epoxy sheets of samples 7 and 8 were manufactured under the same conditions as for samples 1 to 6 except for the above conditions. The evaluation results of samples 7 and 8 are shown in Fig. 3.

<Sample 9>

| Varnish | the same as sample 3 (15 cp) |
|---|---|
| Glass cloth density | 42 warps/25 mm |
| | 32 wefts/25 mm |
| Glass cloth thickness | 180 µm |
| Glass cloth dimensions | width 1,050 mm |
| | length 500 m |

A glass-cloth epoxy sheet of sample 9 was manufactured under the same conditions as for samples 1 to 6 except for the above conditions. The evaluation results of sample 9 are shown in Fig. 3.

<Sample 10>

A glass-cloth epoxy sheet was manufactured under the same conditions as for sample 9 except that a varnish with a viscosity of 130 cp was prepared by using the epoxy resin composition and the solvent mixture used in the formation of samples 1 to 6. The evaluation results of sample 10 are shown in Fig. 3.

<Comparative samples 1 & 2>

Varnishes with viscosities of 1 and 70 cp were prepared by using the epoxy resin composition and the solvent mixture used in samples 1 to 6. A glass-cloth epoxy sheet was manufactured under the same conditions as for samples 1 to 6 except for the viscosities of the varnishes. The evaluation results are shown in Fig. 3. In each of comparative samples 1 and 2, the viscosity of the varnish fell outside the range of 3 to 50 cp, and so unevenness in thickness was large and smoothness was poor. In addition, since the glass cloth content also fell outside the range of 55 to 70 wt%, punching characteristics were poor.

<Comparative sample 3>

In the manufacturing apparatus shown in Fig. 2, in order to adjust the content of the varnish, two bars 10 mm in diameter each formed by closely winding an SUS wire with a diameter of 0.5 mm around a core 9 mm in diameter were provided at staggered positions at a distance of 50 cm from the liquid surface of the varnish 44. The varnish was impregnated into the glass cloth 10 by using the same materials (varnish viscosity 30 cp) as those of sample 6 under the same conditions, and both the surfaces of the glass cloth 10 were wiped by the above bars such that the thickness after the impregnation was 85 µm. Thereafter, the glass cloth 10 thus impregnated was cured under the same conditions as for samples 1 to 6, manufacturing a glass-cloth epoxy sheet (comparative sample 3).

The evaluation results of comparative sample 3 are shown in Fig. 3. Comparative sample 3 had a high flexibility and good punching characteristics because the thickness was 85 µm and the glass cloth content was 63 wt%. Since, however, the glass cloth was brought into contact with the bars after being impregnated with the varnish and before the varnish was cured, evenness in thickness, surface smoothness, and fuzz properties were poor.

<Comparative sample 4>

| Varnish | the same as sample 3 (15 cp) |
|---|---|
| Glass cloth density | 32 warps/25 mm |
| | 25 wefts/25 mm |
| Glass cloth thickness | 280 µm |
| Glass cloth dimensions | width 1,040 mm |
| | length 100 m |

A glass-cloth epoxy sheet was manufactured under the same conditions as for samples 1 to 6 except for the above conditions. The evaluation results of comparative sample 4 are shown in Fig. 3. Comparative sample 4 had nearly good characteristics because the conditions except for the average thickness fell within the range of the embodiment. However, the flexibility of the sheet was poor because of its large thickness.

<Comparative sample 5>

A varnish with a viscosity of 55 cp was prepared by using the epoxy resin composition and the solvent mixture used in samples 1 to 6.

| Varnish temperature | 30°C |
| Glass cloth density | 60 warps/25 mm |
| | 58 wefts/25 mm |
| Glass cloth thickness | 100 μm |
| Glass cloth dimensions | width 1,040 mm |
| | length 600 m |
| Glass cloth running velocity | 1 m/min |
| Drying oven stroke | 20 m |
| Drying oven temperature | 1st chamber 130°C |
| | 2nd to 6th chambers 155°C |
| Far-infrared heater | used |

The evaluation results of comparative sample 5 are shown in Fig. 3. The glass cloth content, the manufacturing method, and the average thickness of comparative sample 5 fell within the range of this embodiment, so the punching characteristics, the fuzz properties, and the flexibility of comparative sample 5 were good. Since, however, the varnish viscosity was 55 cp, evenness in thickness and smoothness were poor.

The measurements and the evaluations shown in Fig. 3 were performed as follows.

<Evaluation of evenness in thickness>

The thickness of each epoxy sheet manufactured was measured in the widthwise direction at an interval of 20 mm, and a thickness variation was calculated by the following equation:

$$\text{thickness variation (\%)}$$

$$= \{(\text{maximum thickness}) - (\text{minimum thickness})\}/\{(\text{average}$$

$$\text{thickness} \times 2) \times 100\} \times 100$$

The present inventors determined that if the thickness variation was within ±10%, evenness in thickness was satisfactory (indicated by o (circle) in Fig. 3) as a condition for coating an adhesive evenly onto a glass-cloth epoxy sheet.

<Glass cloth content>

A square glass-cloth epoxy sheet of 200 mm side was burned in a crucible, and the glass cloth content was calculated by dividing the weight of the burned sheet by the weight of the original sheet. That is,

$$\text{glass cloth content (wt\%)}$$

$$= (\text{weight of burned 200-mm squared glass-cloth epoxy}$$

$$\text{sheet})/(\text{weight of 200-mm squared glass-cloth epoxy}$$

$$\text{sheet}) \times 100$$

<Punching characteristics (punching of holes 1 mm in diameter)>

Holes 1 mm in diameter were punched in each epoxy sheet at an interval of 20 mm in the widthwise direction by using a punch consisting of super hard steel. It was determined that an epoxy sheet in which the peripheral portion of at least one hole was whitened was unsatisfactory. That is,

o (satisfactory): no whitening of 0.2 mm or more was found around any hole
x (unsatisfactory): whitening of 0.2 mm or more was found around at least one hole

<Smoothness>

Three arbitrary portions each 100 mm long in the longitudinal direction were selected from each epoxy sheet manufactured, and undulations in these portions were measured by using a contact continuous thickness meter. It was determined that undulations within ±3 μm were satisfactory.

<Fuzz properties>

It was determined that an epoxy sheet in which one or less fuzz portion was found per $m^2$ by visual observation was good.

<Flexibility>

Each epoxy sheet was wound on a circular pipe 30 mm in diameter and checked by visual observation, and it was determined that the sheet was good if no cracks were found.

An epoxy sheet found to be satisfactory in the evenness in thickness, punching characteristics, smoothness, fuzz properties, and flexibility described above can be used as a printed circuit for mounting LSI chips and the like without causing any problems.

As is apparent from the comparison results (Fig. 3) between the individual samples, the present invention can provide a glass-cloth epoxy sheet excellent in punching characteristics, evenness in thickness, smoothness, fuzz properties, and flexibility and a method of manufacturing this glass-cloth epoxy sheet.

In addition, according to the manufacturing method of the present invention, a varnish is impregnated into a glass-cloth sheet and then cured while being kept out of contact with other members. Therefore, the resultant glass epoxy sheet maintains a necessary smoothness. Yet, microscopically, as shown in Fig. 1, fine undulations resulting form undulations of glass cloth are produced on the surface of the sheet. The glass-cloth epoxy sheet of the present invention therefore exhibits good adhesion properties when it is bonded to other members.

Since the thickness of an epoxy resin layer formed on glass cloth is even, the degree of exposure of the glass cloth is also even when sandblasting is performed. As a result, a glass-cloth epoxy sheet sandblasted evenly can be obtained.

Furthermore, if glass cloth is cured in a clamped state by using a heat press or the like, the glass cloth is cured with strain produced in it. This may cause changes in dimensions of the resultant glass-cloth epoxy sheet during storage or use of the sheet. In the present invention, however, glass cloth is cured with no pressure applied to it, so a glass-cloth epoxy sheet which does not cause any significant dimensional changes can be obtained.

Note that the present invention achieves its effect particularly in the manufacture of a continuous glass-cloth epoxy sheet, but the invention is also applicable to the manufacture of glass-cloth epoxy cut sheets.

**Claims**

1. A method of manufacturing a glass-cloth epoxy sheet, comprising:

   supplying a sheet of glass cloth into an impregnating tank containing varnish prepared by dissolving a curable epoxy resin composition in a solvent, thereby impregnating the resin into the sheet material;
   pulling the sheet material up vertically in a free state from said impregnating tank; followed by
   curing the resin impregnated into the sheet material pulled from the tank, wherein the sheet material is kept vertical and the surfaces of the sheet material are kept out of contact with anything at least during execution of said curing step,
   wherein the viscosity of the varnish contained in said impregnating tank is 3 to 50 cp, and the thickness of the glass-cloth epoxy sheet after curing is 20 to 200 μm.

2. A method according to claim 1, wherein the sheet of glass cloth is supplied continuously.

3. The method of claim 2, wherein glass cloth is supplied from a roll.

4. The method of claim 2 or 3, further comprising applying tension to the sheet material before the impregnation step to prevent formation of wrinkles in the sheet material.

5. The method of claim 2, 3 or 4 further comprising continuously winding up the glass-cloth epoxy sheet, in which the impregnated varnish is cured by the curing step, into the form of a roll.

6. The method accprding to any preceding claim, wherein the cured state of the resin after the curing step is at least a state in which the surface of the resin impregnated into the sheet material is not damaged even if it is brought into contact with a roll.

7. The method according to any preceding claim, wherein the cured state of the resin achieved by the curing step is at least a state in which a weave pattern of the glass cloth does not deform even upon application of an external force within an elastic deformation limit of the sheet material.

8. The method according to any preceding claim, wherein the sheet material is brought into contact with one or a plurality of rolls provided in said impregnating tank.

9. The method according to any preceding claim, wherein a pulling rate of the sheet material is at a rate at which the varnish contained in said impregnating tank does not ripple.

10. An apparatus for manufacturing a glass-cloth epoxy sheet, comprising:

impregnating means for supplying a sheet material of glass cloth into an impregnating tank containing a varnish prepared by dissolving a curable epoxy resin composition into a solvent, thereby impregnating the resin into the sheet material;
pulling means for pulling up the sheet material vertically in a free state from said impregnating tank; and curing means for curing the resin impregnated into the sheet material pulled by said pulling means, wherein said curing means keeps the sheet material vertical and the surfaces of the sheet material out of contact with anything, and
wherein the viscosity of the varnish contained in said impregnating tank is 3 to 50 cp, and the thickness of the glass-cloth epoxy sheet after curing is 20 to 200 μm.

11. An apparatus for manufacturing a glass-cloth epoxy sheet, comprising:

supply means for continuously supplying a sheet material of glass cloth;
impregnating means for dipping the sheet material into an impregnating tank containing a varnish prepared by dissolving a curable epoxy resin composition into a solvent, thereby impregnating the resin into the sheet material;
pulling means for contiuously pulling up the sheet material vertically in a free state from said impregnating tank and
curing means for curing the resin impregnated into the sheet material pulled by said pulling means, wherein said curing means keeps the sheet material vertical and the surfaces of the sheet material out of contact with anything, and
wherein the viscosity of the varnish contained in said impregnating tank is 3 to 50 cp, and the thickness of the glass-cloth epoxy sheet after curing is 20 to 200 μm.

12. The apparatus according to claim 11, wherein said supply means continuously supplies a continuous sheet material of glass cloth from a sheet roll.

13. The apparatus according to claim 11 or 12, further comprising:
means for preventing formation of wrinkles in the sheet material by applying a proper tension to the sheet material supplied by said supply means before impregnation is executed by said impregnating means.

14. The apparatus according to claim 10, 11, 12 or 13, further comprising:

winding means for continuously winding up the cured glass-cloth epoxy sheet into the form of a roll.

15. The apparatus according to any of claims 10 to 14, wherein the cured state of the resin achieved by said curing means is at least a state in which the surface of the resin impregnated into the sheet material is not damaged even if it is brought into contact with a roll.

16. The apparatus according to any of claims 10 to 15, wherein the cured state of the resin achieved by said curing means is at least a state in which a weave pattern of the glass cloth does not deform even upon application of an external force within an elastic deformation limit to the sheet material.

17. The apparatus according to any of claims 10 to 16, further comprising one or a plurality of rolls in said impregnating tank, which are contacted by the sheet material.

18. A glass-cloth epoxy sheet obtainable according to the methods of claims 1-9;
      wherein the thickness of said glass-cloth epoxy sheet has a value X ranging between 20 µm and 75 µm and wherein the percentage by weight of glass cloth in said glass-cloth epoxy sheet is 0.4X + 25 to 70.

19. A glass-cloth epoxy sheet obtainable according to the methods of claims 1-9;
      wherein the thickness of said glass-cloth epoxy sheet has a value ranging between 75 µm and 200 µm and wherein the percentage by weight of glass cloth in said glass-cloth epoxy sheet is 55 to 70.

20. A method for manufacturing resin impregnated glass-cloth, which comprises:

    providing an impregnation station at which the cloth is impregnated with resin liquid; and
    causing the cloth to travel from the impregnation station to a curing station at which it at least partially cured and alters to a state where the surface of the resin liquid impregnated cloth is resistant to damage from contact with a roll,
    wherein the cloth is arranged to travel vertically and freely between the impregnation and curing stations and the at least partial curing operation is performed on the freely vertically travelling cloth, and
    wherein the viscosity of the varnish contained in said impregnating tank is 3 to 50 cp, and the thickness of the glass-cloth epoxy sheet after curing is 20 to 200 µm.

21. A method according to claim 20, wherein the curing is by heat.

22. A method according to claim 21, wherein the curing is by means other than heat.

**Patentansprüche**

1. Verfahren zur Herstellung einer Epoxyharz-Glasfaserfolie, umfassend:

    Zuführen einer Glasfaserbahn in einen Imprägniertank, der einen durch Auflösen einer aushärtbaren Epoxyharz-Zusammensetzung in einem Lösungsmittel erhaltenen Lack enthält, wodurch das Harz in das Bahnmaterial imprägniert wird;
    Herausziehen des Bahnmaterials vertikal in einem freien Zustand aus den Imprägniertank; gefolgt von Aushärten des in dem aus dem Tank herausgezogenen Bahnmaterials imprägnierten Harzes, wobei das Bahnmaterial zumindest während des Aushärtschrittes vertikal gehalten und seine Oberflächen vollständig berührungsfrei gehalten werden,
    wobei die Viskosität des in dem Imprägniertank enthaltenen Lackes 3 bis 50 cp beträgt, und wobei die Dicke der Epoxyharz-Glasfaserfolie nach dem Aushärten 20 bis 200 µm beträgt.

2. Verfahren nach Anspruch 1,
   bei dem die Glasfaserbahn kontinuierlich zugeführt wird.

3. Verfahren nach Anspruch 2,
   bei dem die Glasfaserbahn von einem Wickel zugeführt wird.

4. Verfahren nach Anspruch 2 oder 3,

das desweiteren das Anwenden von Spannung auf das Bahnmaterial vor dem Imprägnierschritt aufweist, um die Ausbildung von Falten im Bahnmaterial zu vermeiden.

5. Verfahren nach Anspruch 2, 3 oder 4,
das desweiteren das kontinuierliche Aufwickeln der Epoxyharz-Glasfaserfolie, in der der imprägnierte Lack in dem Aushärtschritt ausgehärtet ist, in Form eines Wickels umfaßt.

6. Verfahren nach einem der vorangehenden Ansprüche,
wobei der ausgehärtete Zustand des Harzes nach dem Aushärtschritt wenigstens ein Zustand ist, bei dem die Oberfläche des in das Bahnmaterial imprägnierten Harzes nicht beschädigt wird, wenn sie in Berührung mit einem Wickel gebracht wird.

7. Verfahren nach einem der vorangehenden Ansprüche,
wobei der ausgehärtete Zustand des Harzes, der durch den Aushärtschritt erreicht wird, zumindest ein solcher Zustand ist, bei dem ein Webmuster der Glasfaserbahn sich auch bei Anwendung einer externen Kraft innerhalb der elastischen Deformationsgrenze des Bahnmaterials nicht verformt.

8. Verfahren nach einem der vorangehenden Ansprüche,
bei dem das Bahnmaterial im Berührung mit einer oder mehreren Wickeln gebracht wird, die in dem Imprägniertank vorgesehen sind.

9. Verfahren nach einem der vorangehenden Ansprüche,
bei dem eine Herausziehgeschwindigkeit des Bahnmaterials auf eine Geschwindigkeit eingestellt ist, bei der der in dem Imprägniertank enthaltene Lack keine Wellen bildet.

10. Vorrichtung zur Herstellung einer Epoxyharz-Glasfaserfolie mit:

einer Imprägniereinrichtung zum Zuführen eines Glasfaserbahnmaterials in einen Imprägniertank, der einen durch Auflösen einer aushärtbaren Epoxyharzzusammensetzung in einem Lösungsmittel erhaltenen Lack enthält, wobei das Harz in das Bahnmaterial imprägniert wird;
einer Herauszieheinrichtung zum Herausziehen des Bahnmaterials vertikal in einem freien Zustand aus dem Imprägniertank; und
einer Aushärteinrichtung zum Aushärten des in das von der Herauszieheinrichtung herausgezogenen Bahnmaterial imprägnierten Harzes, wobei die Aushärteinrichtung das Bahnmaterial vertikal hält und seine Oberflächen völlig berührungsfrei hält, und
wobei die Viskosität des in dem Imprägniertank enthaltenen Lacks 3 bis 50 cp und die Dicke der Epoxyharz-Glasfaserfolie nach dem Aushärten 20 bis 200 μm beträgt.

11. Vorrichtung zur Herstellung einer Epoxyharz-Glasfaserfolie mit:

einer Zufuhreinrichtung zum kontinuierlichen Zuführen eines Bahnmaterials aus Glasfaser;
einer Imprägniereinrichtung zum Eintauchen des Bahnmaterials in einen Imprägniertank, der einen durch Auflösen einer aushärtbaren Epoxyharz-Zusammensetzung in einem Lösungsmittel erhaltenen Lack enthält, wobei das Harz in das Bahnmaterial imprägniert wird;
einer Herauszieheinrichtung zum kontinuierlichen Herausziehen des Bahnmaterials vertikal in einem freien Zustand aus dem Imprägniertank und
einer Aushärteinrichtung zum Aushärten des in das von der Herauszieheinrichtung herausgezogenen Bahnmaterials imprägnierten Harzes, wobei die Aushärteinrichtung das Bahnmaterial vertikal hält und seine Oberflächen völlig berührungsfrei hält, und
wobei die Viskosität des in dem Imprägniertank enthaltenen Lackes 3 bis 50 cp und die Dicke der Epoxyharz-Glasfaserfolie nach dem Aushärten 20 bis 200 μm beträgt.

12. Vorrichtung nach Anspruch 11,
bei dem die Zufuhreinrichtung kontinuierlich ein kontinuierliches Bahnmaterial aus Glasfaser von einem Bahnwickel zuführt.

13. Vorrichtung nach Anspruch 11 oder 12,
die desweiteren enthält:

eine Einrichtung zum Vermeiden der Ausbildung von Falten in dem Bahnmaterial durch Anwenden einer geeigneten Spannung auf das von der Zufuhreinrichtung zugeführte Bahnmaterial, bevor die Imprägnierung durch die Imprägniereinrichtung ausgeführt wird.

**14.** Vorrichtung nach Anspruch 10, 11, 12 oder 13,
die desweiteren enthält:
Aufwickeleinrichtung zum kontinuierlichen Aufwickeln der ausgehärteten Epoxyharz-Glasfaserfolie in Form eines Wickels.

**15.** Vorrichtung nach einem der Ansprüche 10 bis 14,
bei dem der ausgehärtete Zustand des Harzes, der durch die Aushärteinrichtung erreicht wird, zumindest ein Zustand ist, bei dem die Oberfläche des in das Bahnmaterial imprägnierten Harzes nicht beschädigt wird, wenn es in Berührung mit einem Wickel gebracht wird.

**16.** Vorrichtung nach einem der Ansprüche 10 bis 15,
bei dem der ausgehärtete Zustand des Harzes, der durch die Aushärteinrichtung erreicht wird, zumindest ein Zustand ist, bei dem ein Webmuster der Glasfaserbahn sich auch bei Anwendung einer externen Kraft innerhalb der elastischen Deformationsgrenze des Bahnmaterials nicht deformiert.

**17.** Vorrichtung nach einem der Ansprüche 10 bis 16, die desweiteren eine oder eine Mehrzahl von Wickeln in dem Imprägniertank enthält, die mit dem Bahnmaterial in Berührung stehen.

**18.** Epoxyharz-Glasfaserfolie, die nach dem Verfahren der Ansprüche 1 bis 9 erhaltbar ist,
wobei die Dicke der Epoxyharz-Glasfaserfolie einen Wert X im Bereich zwischen 20 µm und 75 µm hat, und wobei der Gewichtsprozentsatz der Glasfaserbahn in der Epoxyharz-Glasfaserfolie gleich 0,4 X + 25 bis 70 ist.

**19.** Epoxyharz-Glasfaserfolie, die nach dem Verfahren der Ansprüche 1 bis 9 erhaltbar ist, wobei die Dicke der Epoxyharz-Glasfaserfolie einen Wert im Bereich zwischen 75 µm und 200 µm hat, und wobei der Gewichtsprozentsatz der Glasfaserbahn in der Epoxyharz-Glasfaserfolie zwischen 55 und 70 beträgt.

**20.** Verfahren zur Herstellung einer harzimprägnierten Glasfaserfolie, umfassend:

Vorsehen eines Imprägnierabschnittes, bei dem die Bahn mit Flüssigharz imprägniert wird; und
Veranlassen, daß die Bahn von dem Imprägnierabschnitt zu einem Aushärtabschnitt transportiert wird, bei dem sie zumindest teilweise aushärtet und in einen Zustand übergeht, in dem die Oberfläche der flüssigharzimprägnierten Bahn resistent gegen Beschädigung durch Berührung mit einem Wickel ist,
wobei die Bahn für eine vertikale und freie Bewegung zwischen dem Imprägnier- und dem Aushärtabschnitt angeordnet ist, und wobei der zumindest teilweise Aushärtvorgang and der sich frei vertikal bewegenden Bahn ausgeführt wird, und
wobei die Viskosität des in dem Imprägniertank enthaltenen Lacks 3 bis 50 cp und die Dicke der Epoxyharz-Glasfaserfolie nach dem Aushärten 20 bis 200 µm beträgt.

**21.** Verfahren nach Anspruch 20,
bei dem das Aushärten mittels Wärme erfolgt.

**22.** Verfahren nach Anspruch 21,
bei dem die Aushärtung mittels anderer Mittel als Wärme erfolgt.

**Revendications**

**1.** Un procédé de fabrication d'une natte de verre dc résine époxy, comprenant les étapes consistant à :

disposer une feuille de tissu de verre dans une cuve d'imprégnation contenant du vernis préparé en dissolvant une composition de résine epoxy durcissable dans un solvant, de manière à imprégner le matériau en feuille de résine ;
tirer le matériau en feuille vers le haut verticalement à l'état libre de ladite cuve d'imprégnation suivies des étapes consistant à

durcir la résine imprégnant le matériau en feuille tiré de la cuve, dans lequel le matériau en feuille est maintenu vertical et les surfaces du matériau vertical ne touchant aucun élément au moins pendant l'exécution de ladite étape de durcissement,

dans lequel la viscosité du vernis contenu dans ladite cuve d'imprégnation est de 3 à 50 cp, et l'épaisseur de la natte de verre de résine époxy après durcissement est de 20 à 200 μm.

2. Un procédé selon la revendication 1, dans lequel la feuille de tissu de verre est amenée en continu.

3. Le procédé selon la revendication 2, dans lequel le tissu de verre est amené depuis un rouleau.

4. Le procédé selon la revendication 2 ou 3, comprenant en outre l'application d'une tension au matériau en feuille avant l'étape d'imprégnation afin d'éviter la formation de plis dans le matériau en feuille.

5. Le procédé selon une quelconque des revendications 2, 3 ou 4, comprenant en outre l'enroulement simultané de la natte de verre de résine époxy, dans lequel le vernis imprégnant est durci par l'étape de durcissement, sous la forme d'un rouleau.

6. Le procédé selon l'une quelconque des revendications précédentes, dans lequel l'état durci de la résine après l'étape de durcissement est au moins un état dans lequel la surface de la résine imprégnant le matériau en feuille n'est pas endommagée même si elle est mise au contact d'un rouleau.

7. Le procédé selon l'une quelconque des revendications précédentes, dans lequel l'état durci de la résine obtenu par l'étape de durcissement est au moins un état dans lequel le dessin d'armure du tissu de verre ne se déforme pas même lors de l'application d'une force extérieure dans la limite de déformation élastique du matériau en feuille.

8. Le procédé selon l'une quelconque des revendications précédentes, dans lequel le matériau en feuille est mis au contact d'un ou de plusieurs cylindres disposés dans ladite cuve d'imprégnation.

9. Le procédé selon l'une quelconque des revendications précédentes, dans lequel la vitesse de tirage du matériau en feuille est une vitesse à laquelle le vernis contenu dans ladite cuvc d'imprégnation ne se ride pas.

10. Un appareil pour fabriquer une natte de verre de résine époxy, comprenant :

des moyens d'imprégnation pour amener un matériau en feuille de tissu de verre dans une cuve d'imprégnation contenant un vernis préparé en dissolvant une composition de résine époxy durcissable dans un solvant, de manière à imprégner le matériau en feuille de résine ;

des moyens de tirage pour tirer le matériau en feuille vers le haut verticalement à l'état libre de ladite cuve d'imprégnation ; et

des moyens de durcissement pour durcir la résine imprégnant le matériau en feuille tiré par lesdits moyens de tirage. dans lequel lesdits moyens de tirage maintiennent le matériau en feuille vertical et les surfaces du matériau en feuille hors de contact avec quoi que soit, et

dans lequel la viscosité du vernis contenu dans ladite cuve d'imprégnation est de 3 à 50 cp, et l'épaisseur de la natte de verre de résine époxy après durcissement est de 20 à 200 μm.

11. Un appareil pour fabriquer une natte de verre de résine époxy, comprenant :

des moyens de distribution pour amener en continu un matériau en feuille de tissu de verre ;

des moyens d'imprégnation pour plonger le matériau en feuille dans une cuve d'imprégnation contenant un vernis préparé en dissolvant une composition de résine époxy durcissable dans un solvant. de manière à imprégner de résine le matériau en feuille ;

des moyens de tirage pour tirer en continu le matériau en feuille vers le haut verticalement à l'état libre de ladite cuve d'imprégnation ; et

des moyens de durcissement pour durcir la résine imprégnant le matériau en feuille tiré par lesdits moyens de tirage, dans lequel lesdits moyens de durcissement maintiennent le matériau en feuille vertical et les surfaces du matériau en feuille hors de contact avec quoi que soit, et

dans lequel la viscosité du vernis contenu dans ladite cuve d'imprégnation est de 3 à 50 cp, et l'épaisseur de la natte de verre de résine époxy après durcissement est de 20 à 200 μm.

**12.** L'appareil selon la revendication 11, dans lequel lesdits moyens de distribution amènent en continu un matériau en feuille continue de tissu de verre depuis un rouleau de feuille.

**13.** L'appareil selon une quelconque des revendications 11 ou 12, comprenant en outre :
des moyens pour éviter la formation de plis dans le matériau en feuille en appliquant une tension appropriée au matériau en feuille distribué par lesdits moyens de distribution avant mise en oeuvre de l'imprégnation par lesdits moyens d'imprégnation.

**14.** L'appareil selon une quelconque des revendications 10, 11, 12 ou 13, comprenant en outre :
des moyens d'enroulement destinés à enrouler en continu la natte de verre de résine époxy durcie sous forme d'un rouleau.

**15.** L'appareil selon l'une quelconque des revendications 10 à 14, dans lequel l'état durci de la résine obtenu par lesdits moyens de durcissement est au moins un état dans lequel la surface de la résine imprégnant le matériau en feuille n'est pas endommagée même si elle est mise au contact d'un cylindre.

**16.** L'appareil selon l'une quelconque des revendications 10 à 15, dans lequel l'état durci de la résine obtenu par lesdits moyens de durcissement est au moins un état dans lequel le dessin d'armure du tissu de verre ne se déforme pas même lors de l'application d'une force extérieure dans lalimite de déformation élastique du matériau en feuille.

**17.** L'appareil selon l'une quelconque des revendications 10 à 16, comprenant en outre un ou une pluralité de cylindres dans ladite cuve d'imprégnation au contact desquels vient le matériau en feuille.

**18.** Une natte de verre de résine époxy, pouvant être obtenue selon un prodédé selon une quelconque des revendications 1 à 9 ;
dans laquelle l'épaisseur de ladite natte de verre de résine époxy a une valeur X comprise entre 20 µm et 75 µm et dans laquelle le pourcentage en poids de tissu de verre dans ladite natte de verre de résine époxy est de 0.4 X + 25 à 70.

**19.** Une natte de verre de résine époxy pouvant être obtenue selon un procédé selon quelconque des revendications 1 à 9 ;
dans laquelle l'épaisseur de ladite natte de verre de résine époxy a une valeur comprise entre 75 µm et 200 µm et dans laquelle le pourcentage en poids de tissu de verre dans ladite natte de verre de résine époxy est de 55 à 70.

**20.** Un procédé de fabrication de natte de verre de résine époxy, qui comprend:

disposer d'un poste d'imprégnation dans lequel le tissu est imprégné d'une résine liquide ; et
assurer le transfert du tissu du poste d'imprégnation à un poste de durcissement dans lequel il est au moins partiellement durci et modifié pour atteindre un état dans lequel la surface du tissu imprégné de résine liquide résiste à l'endommagement provoqué par le contact avec un cylindre,
dans lequel le tissu est agencé pour se déplacer verticalement et librement entre le poste d'imprégnation et les postes de durcissement et ladite au moins une opération de durcissement partiel est réalisée sur le tissu en déplacement vertical à l'état libre, et
dans lequel la viscosité du vernis contenu dans ladite cuve d'imprégnation est de 3 à 50 cp, et l'épaisseur de la natte de verre de résine époxy après durcissement est de 20 à 200 µm.

**21.** Un procédé selon la revendication 20, dans lequel le durcissement se fait par la chaleur.

**22.** Un procédé selon la revendication 21. dans lequel le durcissement se fait par d'autres moyens que la chaleur.

EP 0 588 648 B1

# FIG. 1

101: GLASS CLOTH

1010: WARPS OF
GLASS CLOTH

1011: WEFTS OF
GLASS CLOTH

103

102: EPOXY RESIN
COMPOSITION

100

FIG. 2

5: DRYING OVEN

513 51 52 514

512 515

511 516

TEMPERATURE CONTROL UNIT 501

TEMPERATURE CONTROL UNIT 701

7: FAR-INFRARED HEATER

1: SHEET ROLL

10: GLASS CLOTH

2

6

8: EPOXY SHEET ROLL

3: PUSH BAR

41

403

VERNISH SUPPLY CONTROL UNIT 401

801 WIND-UP MOTOR

VELOCITY CONTROL UNIT 802

405

44

42 43

HEATER

404

VERNISH SUPPLY UNIT 402

4: IMPREGNATING TANK

EP 0 588 648 B1

17

# FIG. 3

| No. | VISCOSITY cp | AVERAGE THICKNESS μm | EVENNESS IN THICKNESS (THICKNESS VARIATION±%) | GLASS CLOTH CONTENT wt% | PUNCHING CHARACTERISTICS | SMOOTHNESS | FUZZ PROPERTIES | FLEXIBILITY |
|---|---|---|---|---|---|---|---|---|
| SAMPLE 1 | 5 | 82 | ○ ( 6 ) | 66 | ○ | ○ | ○ | ○ |
| SAMPLE 2 | 10 | 83 | ○ ( 6 ) | 64 | ○ | ○ | ○ | ○ |
| SAMPLE 3 | 15 | 85 | ○ ( 4 ) | 62 | ○ | ○ | ○ | ○ |
| SAMPLE 4 | 20 | 86 | ○ ( 5 ) | 59 | ○ | ○ | ○ | ○ |
| SAMPLE 5 | 25 | 88 | ○ ( 6 ) | 57 | ○ | ○ | ○ | ○ |
| SAMPLE 6 | 30 | 90 | ○ ( 3 ) | 56 | ○ | ○ | ○ | ○ |
| SAMPLE 7 | 15 | 30 | ○ ( 7 ) | 50 | ○ | ○ | ○ | ○ |
| SAMPLE 8 | 20 | 31 | ○ ( 6 ) | 46 | ○ | ○ | ○ | ○ |
| SAMPLE 9 | 15 | 182 | ○ ( 5 ) | 56 | ○ | ○ | ○ | ○ |
| SAMPLE 10 | 13 | 182 | ○ ( 8 ) | 57 | ○ | ○ | ○ | ○ |
| COMPARATIVE SAMPLE 1 | 1 | 80 | × ( 11 ) | 81 | × | × | ○ | ○ |
| COMPARATIVE SAMPLE 2 | 70 | 92 | × ( 20 ) | 40 | × | × | ○ | ○ |
| COMPARATIVE SAMPLE 3 | 30 | 85 | × ( 15 ) | 63 | ○ | × | × | ○ |
| COMPARATIVE SAMPLE 4 | 15 | 285 | ○ ( 4 ) | 63 | ○ | ○ | ○ | × |
| COMPARATIVE SAMPLE 5 | 55 | 105 | × ( 15 ) | 60 | ○ | × | ○ | ○ |

EP 0 588 648 B1